Europäisches Patentamt

European Patent Office

Office européen des brevets

(19)

(11) Veröffentlichungsnummer: **0 100 009**
**B1**

(12) **EUROPÄISCHE PATENTSCHRIFT**

(45) Veröffentlichungstag der Patentschrift:
**13.11.85**

(21) Anmeldenummer: **83106710.3**

(22) Anmeldetag: **08.07.83**

(51) Int. Cl.⁴: **G 01 R 33/14**

(54) Vorrichtung zum zerstörungsfreien Messen der Einhärtetiefe von Werkstoffen.

(30) Priorität: **09.07.82 DE 3225743**

(43) Veröffentlichungstag der Anmeldung:
**08.02.84 Patentblatt 84/6**

(45) Bekanntmachung des Hinweises auf die Patenterteilung:
**13.11.85 Patentblatt 85/46**

(84) Benannte Vertragsstaaten:
**AT BE CH DE FR GB IT LI NL SE**

(56) Entgegenhaltungen:
**DE - A - 2 837 733**
**DE - A - 3 037 932**

**JOURNAL PHYSICS E: SCIENTIFIC INSTRUMENTS,**
**Band 11, 1978, London, R. TER STEGE et al. "Equipment**
**for the Investigation of statistical properties of the**
**Barkhausen effect", Seiten 791-793**

(73) Patentinhaber: **Fraunhofer-Gesellschaft zur Förderung der angewandten Forschung e.V., Leonrodstrasse 54, D-8000 München 19 (DE)**

(72) Erfinder: **Persch, Helmut, Dipl.-Ing., Freiherr-v.-Stein-Strasse 4, D-6682 Ottweiler (DE)**
Erfinder: **Theiner, Werner, Dr. rer. nat., Am Homburg 44, D-6600 Saarbrücken (DE)**

(74) Vertreter: **Rackette, Karl, Dipl.-Phys. Dr.-Ing, Kaiser-Joseph-Strasse 179 Postfach 1310, D-7800 Freiburg (DE)**

## Beschreibung

Die Erfindung bezieht sich auf eine Vorrichtung zum zerstörungsfreien Messen der Einhärtetiefe von Werkstoff mit einem auf das zu untersuchende Material mit seinen beiden Magnetpolen aufsetzbaren Magnetisierungsjoch, dessen Erregerspule zum Durchsteuern der Hysteresekurve des zu untersuchenden Materials mit einem bipolaren Netzgerät verbunden ist und zwischen dessen Magnetpolen ein H-Feldmesser zur Erfassung der Tangentialfeldstärke angeordnet ist.

Eine solche Vorrichtung ist aus der DE-AI-30 37 932 bekannt und verfügt zusätzlich zu dem H-Feldmesser zwischen den Magnetpolen über einen induktiven Aufnehmer zum Erfassen des Barkhausenrauschens oder über eine Wirbelstromspule, mit deren Hilfe die Überlagerungspermeabilität des Werkstoffes während des Durchsteuerns der Hysteresekurve erfaßbar ist. Während die mit einem induktiven Aufnehmer ausgerüstete Vorrichtung die Koerzitivfeldstärke des untersuchten Werkstoffes durch Auswerten des Rauschmaximums und Bestimmen der dem Rauschmaximum zugeordneten Tangentialfeldstärke ermittelt, ermittelt die mit der Wirbelstromspule ausgerüstete Vorrichtung die Koerzitivfeldstärke dadurch, daß die von der Überlagerungspermeabilität des untersuchten Werkstoffes abhängige Impedanz der Wirbelstromspule gemessen wird und die der maximalen Impedanz zugeordnete Tangentialfeldstärke zur Bestimmung der Koerzitivfeldstärke herangezogen wird.

Sowohl die mit dem induktiven Aufnehmer zur Erfassung des Barkhausenrauschens ausgerüstete Vorrichtung, als auch die mit der Wirbelstromspule ausgerüstete Vorrichtung gestatten lediglich eine Aussage über die im jeweiligen Wechselwirkungsvolumen der Meßvorrichtungen vorhandene Koerzitivfeldstärke ohne Aussage über deren Verteilung. Aus diesem Grund können durch die Messungen der Koerzitivfeldstärke lediglich globale Aussagen über die mechanische Härte, die oft mit der Koerzitivfeldstärke korreliert (Zeitschrift für Metallkunde, Bd. 46 (1955), H. 5, S. 364/365) gemacht werden.

Ausgehend von diesem Stand der Technik liegt der Erfindung die Aufgabe zugrunde, Vorrichtungen der eingangs genannten Art zu schaffen, die eine Bestimmung des Härteverlaufes rechtwinklig zur Oberfläche des untersuchten Werkstoffes gestatten.

Diese Aufgabe wird erfindungsgemäß dadurch gelöst, daß bei einer Vorrichtung mit einem induktiven Aufnehmer zum Erfassen des Barkhausenrauschens der induktive Aufnehmer den das Barkhausenrauschen messenden Schaltkreis über ein verstellbares Filter speist, dessen Durchlaßfrequenz durch eine Auswerteschaltung während eines Meßzyklus so weit erhöhbar ist, bis das dem Grundgefüge zugeordnete bei der Koerzitivfeldstärke des Grundgefüges auftretende Rauschmaximum unterdrückt und lediglich das bei der Koerzitivfeldstärke des Deckgefüges auftretende Rauschmaximum meßbar ist, und daß die der so durch die Auswerteschaltung ermittelten Grenzfrequenz zugeordnete Einhärtetiefe über eine Anzeigevorrichtung darstellbar ist.

Bei der mit der Wirbelstromspule ausgerüsteten Vorrichtung ist die Anordnung erfindungsgemäß so getroffen, daß dem Impedanzmeßschaltkreis eine Auswerteschaltung zugeordnet ist, durch die die Prüffrequenz des die Wirbelstromspule speisenden Wechselstromgenerators verstellbar und durch die die der Einhärtetiefe zugeordnete Prüffrequenz feststellbar ist, bei der durch eine Veränderung der Prüffrequenz eine maximale Veränderung der einem Impedanzmaximum während des Durchsteuerns der Hysteresekurve zugeordneten Tangentialfeldstärke auslösbar ist.

Die Erfindung gestattet es somit, nicht nur durch Bestimmen der Koerzitivfeldstärke eine Aussage über die Härte der Werkstoffprobe zu machen, sondern auch darüber, wie dick die auf einer Werkstoffprobe vorhandene gehärtete Deckschicht ist. Dadurch kann auf umständlich durchzuführende metallographische zerstörende Prüfverfahren verzichtet werden, bei denen senkrecht zur Oberfläche des Prüflings ein Schliff hergestellt werden muß, um die Einhärtetiefe durch Mikrohärtemessung festzustellen. Gegenüber den auf Remanenzmessungen beruhenden Verfahren zur Bestimmung der Härtetiefe zeichnet sich die Erfindung ebenfalls dadurch aus, daß die Bestimmung der Einhärtetiefe schnell mit geringem Meßaufwand in Aufsetztechnik möglich ist.

Im folgenden wird die Erfindung anhand von zwei Ausführungsbeispiele darstellenden Zeichnungen näher erläutert. Es zeigt:

Fig. 1 ein Blockschaltbild eines ersten Ausführungsbeispiels der erfindungsgemäßen Vorrichtung, bei der das auszuwertende Signal von einem induktiven Aufnehmer geliefert wird und

Fig. 2 ein Blockschaltbild eines zweiten Ausführungsbeispiels der erfindungsgemäßen Vorrichtung, bei der das auszuwertende Signal mit Hilfe einer Wirbelstromspule gewonnen wird.

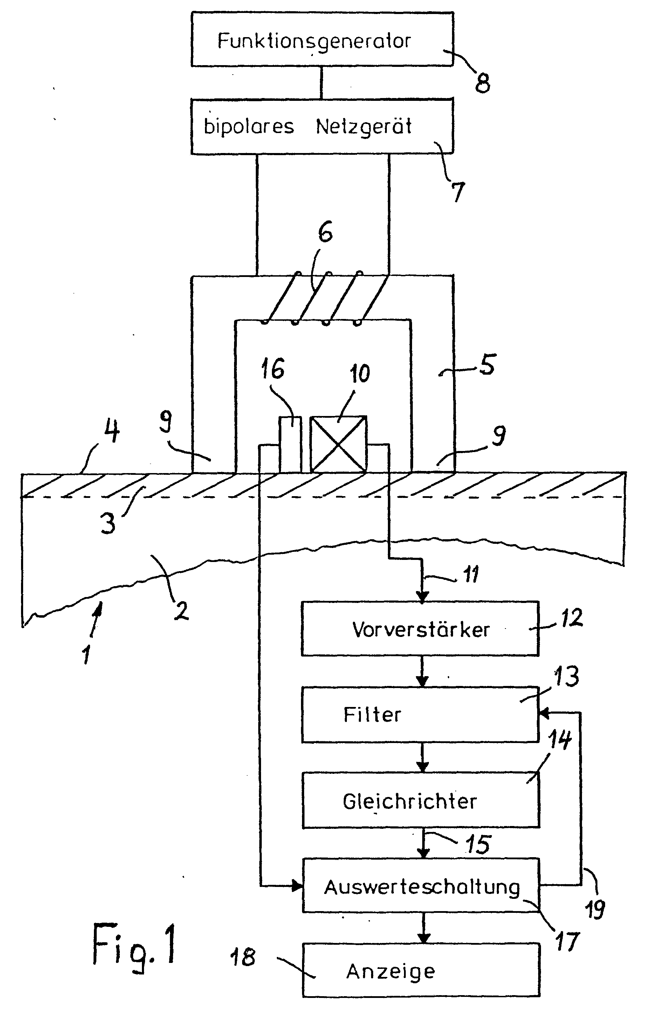

In Fig. 1 ist vergrößert und schematisch ein Prüfling 1 dargestellt, der aus einem ferromagnetischen Material besteht und auf einem verhältnismäßig weichen Grundgefüge 2 eine harte Deckschicht 3 aufweist. Die in Fig. 1 schematisch dargestellte erfindungsgemäße Vorrichtung gestattet es, die Dicke der Deckschicht 3 und somit die Einhärtetiefe zerstörungsfrei zu bestimmen.

Dazu ist auf der Oberfläche 4 des Prüflings 1 ein Magnetisierungsjoch 5 aufgesetzt, dessen schematisch durch einige Windungen dargestellte Erregerspule 6 mit den Ausgängen eines bipolaren Netzgerätes 7 verbunden ist. Das bipolare Netzgerät 7 wird mit Hilfe eines Funktionsgenerators 8 gesteuert, so daß das bipolare Netzgerät 7 beispielsweise einen sägezahnförmigen Strom in die Erregerspule 6 einprägt. Dadurch entsteht an den Enden 9 des Magnetisierungsjoches 5 abwechselnd ein Nordpol und ein Südpol und in dem über den Prüfling geschlossenen Magnetkreis ein magnetischer Fluß, durch den die Hysteresekurve des Pfüflings 1 mit der Deckschicht 3 und dem Grundgefüge 2 durchgesteuert wird. Die Frequenz der Durchsteuerung liegt zwischen 0,1 und 1000 Hz, vorzugsweise zwischen etwa 20 und 200 Hz.

Bei der Durchsteuerung der Hysteresekurve werden die Blochwände des Prüflings 1 durch Wechselwirkung mit Gitterdefekten und untereinander in Potentialmulden festgehalten. Durch das vom Magnetisierungsjoch 5 erzeugte Magnetfeld werden Kräfte auf die Blochwände ausgeübt und sobald ein Potentialberg überschritten ist, bewegt sich die betreffende Blochwand, bis sie an einem anderen Potentialberg hängenbleibt. Diese impulsartige Magnetisierungsänderung induziert ein Spektrum von Mikro-Wirbelströmen, die an der Oberfläche 4 des Prüflings 1 gemessen werden können. Bei genauerer Auflösung der Hysteresekurve zeigt sich, daß diese eigentlich sägezahnförmig verläuft und daß der Prüfling 1 nicht nur kontinuierlich magnetisiert wird, sondern daß sprunghafte Magnetisierungsänderungen auftreten. Die sprunghaften Blochwandbewegungen, die ein Barkhausenereignis darstellen, erzeugen somit ein kontinuierliches Spektrum von Wirbelströmen, dessen einzelne Frequenzkomponenten auf ihrem Laufweg zur Oberfläche 4 infolge der frequenzabhängigen Wirbelstromdämpfung unterschiedlich abgeschwächt werden. Dabei gilt für die frequenzabhängige Wirbelstromdämpfung d:

$$d \sim \exp - \sqrt{f} \qquad (f = \text{Frequenz})$$

Aus diesem Grund gelangen die hochfrequenten Anteile des Barkhausenrauschens stärker gedämpft als die niederfrequenten Anteile zur Oberfläche 4.

Das sowohl von dem Grundgefüge 2 als auch von der Deckschicht 3 bei der Durchsteuerung der Hysteresekurve ausgehende Barkhausenrauschen wird mit Hilfe eines induktiven Aufnehmers 10 erfaßt, der gegen die Oberfläche 4 des Prüflings 1 anliegt. Der induktive Aufnehmer 10 kann als Luftspule oder als Tonbandkopf ausgebildet sein und ist über eine abgeschirmte Leitung 11 mit einem Vorverstärker 12 verbunden, dessen Verstärkung beispielsweise 60 dB betragen kann.

Das am Ausgang des Vorverstärkers 12 zur Verfügung stehende breitbandige Spektrum des Barkhausenrauschens gelangt über ein Filter 13 zu einem Gleichrichter 14, so daß am Gleichrichterausgang 15 eine veränderliche Gleichspannung auftritt, deren Amplitude dem vom Filter 13 durchgelassenen Rauschsignal entspricht.

Das im Prüfling 1 erzeugte Barkhausenrauschen verändert während des Durchsteuerns der Hysteresekurve seine Amplitude. Da bei der Bewegung einer 180° Blochwand die Magnetisierungsänderung bezogen auf den Weg maximal ist, tritt das Maximum des Rauschens bei Eisenwerkstoffen dort auf, wo bevorzugt 180° Blochwände bewegt werden. Dies ist bei der Koerzitivfeldstärke $H_c$ der Fall. Die Koerzitivfeldstärke $H_c$ ist mit der Härte korreliert, so daß die beim maximalen Rauschen vorhandene Tangentialfeldstärke an der Oberfläche 4 des Prüflings 1 ein Maß für die im Wechselwirkungsvolumen der Meßanordnung vorhandene Härte ist.

Zur Erfassung der Tangentialfeldstärke ist zwischen den Magnetpolen des Magnetisierungsjoches 5 in der Nähe des induktiven Aufnehmers 10 ein H-Feldmesser 16 angeordnet, der beispielsweise als Hallsonde realisiert sein kann. Der H-Feldmesser 16 ist ebenfalls wie der Gleichrichterausgang 15 elektrisch mit einer Auswerteschaltung 17 verbunden, die u. a. ermittelt, bei welcher vom H-Feldmesser 16 gemessenen Tangentialfeldstärke ein Rauschmaximum auftritt. Bei einem homogenen Pfüfling ergibt sich lediglich ein Rauschmaximum bei einer bestimmten positiven Tangentialfeldstärke und ein entsprechendes Rauschmaximum bei der dem Betrag nach gleichen, aber der Richtung nach entgegengesetzten Tangentialfeldstärke. Diese die Koerzitivfeldstärke $H_c$ darstellenden Tangentialfeldstärken können über eine Anzeigevorrichtung 18 von der Auswerteschaltung 17 ausgegeben werden.

Erfindungsgemäß ist das Filter 13 über eine Steuerleitung 19 durch die Auswerteschaltung 17 in seiner Durchlaßfrequenz verstellbar. Das Filter 13 kann als Bandfilter oder als Hochpaß ausgebildet sein. Über die Steuerleitung 19 ist eine Verstellung derart möglich, daß bei einem Bandfilter die Mittenfrequenz zwischen etwa 1 kHz und 500 kHz oder daß bei einem Hochpaß die Grenzfrequenz zwischen etwa 1 kHz und 500 kHz verstellt werden kann. Auf diese Weise kann die dem Gleichrichter 14 zugeführte Analysierfrequenz zu hohen oder niedrigeren Frequenzen verschoben werden. Infolge der frequenzabhängigen Wirbelstromdämpfung gelangen die hochfrequenten Anteile des Barkhausenrauschens des Grundgefüges 2 nur erheblich abgeschwächt zur Oberfläche 4. Die hochfrequenten Anteile des Barkhausenrauschens der Deckschicht 3 jedoch werden wegen der unmittelbaren Nähe zur Oberfläche 4 nur wenig abgeschwächt. Treten somit bei einer vorgegebenen Einstellung der Mittenfrequenz oder der Grenzfrequenz des Filters 13 im positiven Bereich und im negativen Bereich der Tangentialfeldstärke 2 Rauschmaxima auf, von denen das einer absolut kleineren Tangentialfeldstärke zugeordnete von dem weicheren Grundgefüge 2 und das der einer absolut größeren Tangentialfeldstärke zugeordnete von der härteren Deckschicht 3 verursacht ist, so kann durch ein Erhöhen der Filterfrequenz erreicht werden, daß das dem Grundgefüge 2 zugeordnete Rauschmaximum mehr und mehr unterdrückt wird, weil die hohen Frequenzen des Barkhausenrauschens auf ihrem verhältnismäßig langen Weg zur Oberfläche 4 stärker unterdrückt werden als die entsprechenden Frequenzen des auf die Deckschicht 3 zurückzuführenden Barkhausenrauschens.

Zur Bestimmung der Härtetiefe, z. B. der Einhärtetiefe, wird über den durch die Auswerteschaltung 17, das Filter 13 und den Gleichrichter 14 geschlossenen Regelkreis die Filterfrequenz so lange erhöht, bis das dem weicheren Grundgefüge 2 zugeordnete Barkhausenrauschen nicht mehr festgestellt werden kann. Die dann von der Auswerteschaltung 17 über die Steuerleitung 19 bestimmte Frequenz des Filters 13 ist ein Maß für den Abstand des Grundgefüges 2 von der Oberfläche 4 und damit ein Maß für die Einhärtetiefe und die Dicke der Deckschicht 3. Je größer die Einhärtetiefe und je dicker die Deckschicht 3 ist, umso mehr verschwinden die hochfrequenten Anteile im Barkhausenrauschen des Grundgefüges 2 und umso niedriger ist die von der Auswerteschaltung 17 bestimmte Grenzfrequenz oder Mittenfrequenz des Filters 13, wenn das Rauschmaximum des Barkhausenrauschens des Grundgefüges 2 gerade unterdrückt ist.

Die Auswerteschaltung 17 berechnet die der Grenzfrequenz oder Mittenfrequenz des Filters 13 zugeordnete Analysiertiefe aufgrund der oben erwähnten frequenzabhängigen Wirbelstromdämpfung und zeigt das Ergebnis auf der Anzeigevorrichtung 18 an.

Die in Fig. 1 gezeigte Vorrichtung gestattet es somit, einerseits die Härtetiefe der Deckschicht 3 zu bestimmen, indem eine Frequenz und ein zugehöriger Dämpfungsweg bestimmt werden. Außerdem gestattet es die in Fig. 1 gezeigte Vorrichtung, die Koerzitivfeldstärke des Grundgefüges 2 aufgrund der Lage des ersten Rauschmaximums bezüglich der Tangentialfeldstärke und die Koerzitivfeldstärke der Deckschicht 3 aufgrund der Lage des zweiten Rauschmaximums bezüglich der Tangentialfeldstärke zu bestimmen und über die Anzeigevorrichtung 18 wiederzugeben.

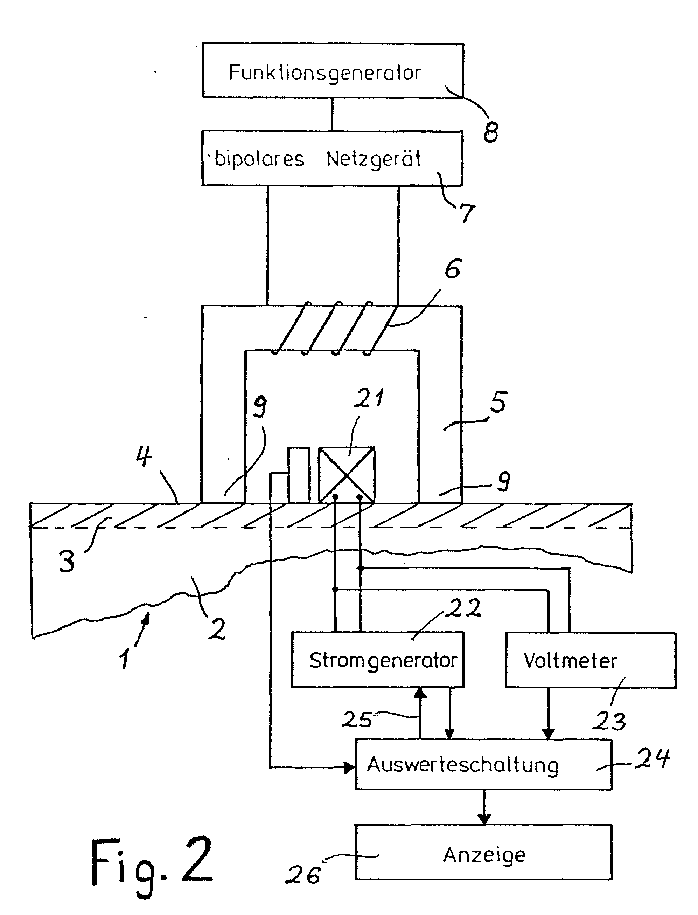

In Fig. 2 ist ein weiteres Ausführungsbeispiel der Erfindung dargestellt, das die Messung der Härtetiefe ebenfalls gestattet.

Die in Fig. 2 dargestellten Teile, die mit den in Fig. 1 dargestellten Teilen übereinstimmen, sind mit den gleichen Bezugszeichen versehen. Insbesondere erkennt man in Fig. 2 den Prüfling 1 mit dem Grundgefüge 2, dem Deckgefüge 3 und der Oberfläche 4, auf der das Magnetisierungsjoch 5 mit der Erregerspule 6 aufgesetzt ist, die über ein bipolares Netzgerät 7 erregt wird, dessen Ausgangsstrom bezüglich der Frequenz und der Form durch den Funktionsgenerator 8 bestimmt ist. Die Frequenz des Funktionsgenerators 8 und damit die Frequenz der Durchsteuerung der Hysteresekurve liegt zwischen etwa 0,1 und 1000 Hz. Vorzugsweise beträgt sie etwa 20 bis 200 Hz.

Wie bei dem Ausführungsbeispiel gemäß Fig. 1, ist zwischen den Enden 9 des Magnetisierungsjoches 5 ein H-Feldmesser 16 angeordnet, durch den die jeweilige Tangentialfeldstärke während des Durchsteuerns der Hysteresekurve gemessen wird. Während des Durchsteuerns der Hysteresekurve verändert sich die Überlagerungspermeabilität. Sie hat in der Umgebung der Koerzitivfeldstärke $H_c$ ein Maximum.

Zur Bestimmung der Überlagerungspermeabilität und damit der Koerzitivfeldstärke $H_c$ sowie der Härte, verfügt die in Fig. 2 dargestellte Vorrichtung über eine Wirbelstromspule 21, die als Pfannkuchenspule oder als Ferritjoch ausgebildet sein kann und durch einen Stromgenerator 22 mit einem Wechselstrom versorgt wird, dessen Frequenz wesentlich höher ist als die Frequenz, mit der die Hysteresekurve durchgesteuert wird. Beim Überlagern des langsam durchgesteuerten Magnetfelds des Magnetisierungsjoches 5 durch das höherfrequente Magnetfeld der Wirbelstromspule 21 niedrigerer Amplitude, werden auf der Hysteresekurve lanzettförmige innere Schleifen durchgesteuert. Die dem höherfrequenten in die Wirbelstromspule 21 eingeprägten Strom zugeordnete Spannung wird mit einem Volltreffer 23 gemessen. Auf diese Weise kann die Impedanz der Wirbelstromspule 21 aus dem jeweiligen Strom und der jeweiligen Spannung ermittelt werden. Die jeweils ermittelte Impedanz ist eine Funktion der Überlagerungspermeabilität und ist daher bei der Koerzitivfeldstärke am größten. Aus diesem Grund ergibt sich ein Maximum der Impedanz der Wirbelstromspule 21, wenn die vom H-Feldmesser erfaßte Tangentialfeldstärke der Koerzitivfeldstärke entspricht.

Die Auswerteschaltung 24 bestimmt aus den vom Stromgenerator 22 eingeprägten Stromwerten und den vom Voltmeter 23 gemessenen Spannungswerten die jeweilige Impedanz der Wirbelstromspule 21 und gestattet die Bestimmung und die Anzeige derjenigen Tangentialfeldstärke, bei der die gemessene bzw. errechnete Impedanz maximal ist.

Die Prüffrequenz des Stromgenerators 22 kann über eine Steuerleitung 25 von der Auswerteschaltung 24 zwischen 1 kHz und 100 MHz, vorzugsweise zwischen 20 kHz und 2 MHz verstellt werden. In Abhängigkeit von der jeweiligen Stromgeneratorfrequenz ergibt sich für das Feld der Wirbelstromspule 21 eine Eindringtiefe $\delta$ gemäß der Gleichung

$$\delta = \frac{1}{\sqrt{\mu_A \cdot f \cdot \sigma}}$$

worin f die Prüffrequenz, $\mu_A$ die Überlagerungspermeabilität und $\sigma$ die Leitfähigkeit des jeweiligen Mediums ist.

Über die Steuerleitung 25 ist es der Auswerteschaltung 24 daher möglich, über eine Änderung der Prüffrequenz des Stromgenerators 22 die Eindringtiefe des Feldes der Wirbelstromspule 21 festzulegen.

Bei niedrigen Prüffrequenzen für den Stromgenerator 22 ergibt sich aufgrund der oben erwähnten Standardeindringtiefe eine große Analysiertiefe für die Impedanzmessung und damit die Koerzitivfeldstärke. Die Auswerteschaltung 24 ist so aufgebaut, daß sie während einer Tiefenprofilmessung, bei der die Hysteresekurve mehrfach durchgesteuert wird, die Prüffrequenz des Stromgenerators 22 nach jeder durchgesteuerten Hysteresekurve erhöht. Dadurch verringert sich laufend die Analysiertiefe und das Wechselwirkungsvolumen. Bei sehr niedrigen Prüffrequenzen und hohen Analysiertiefen verschiebt sich die Lage des Maximums der von der Auswerteschaltung 24 berechneten Impedanz bezüglich der vom H-Feldmesser jeweils erfaßten Tangentialfeldstärke nur unwesentlich. Im Verlauf der Erhöhungen der Prüffrequenz für jede nachfolgende Durchsteuerung der Hysteresekurve wird bei einer Eindringtiefe in der Größenordnung der Einhärtetiefe ein Punkt erreicht, bei dem das Impedanzmaximum während des Durchsteuerns der Hysteresekurve in bezug auf die Tangentialfeldstärke schneller zu größeren Feldstärkewerten wandert. Bei weiteren Erhöhungen der Prüffrequenz während nachfolgender Hysteresekurven verschiebt sich die Lage des Impedanzmaximums erneut geringfügiger, wenn die Eindringtiefe des Feldes der Wirbelstromspule 21 geringer als die Dicke der Deckschicht 3 ist.

Zur Bestimmung der Einhärtetiefe ermittelt die Auswerteschaltung 24 somit für alle Hysteresekurven die Tangentialfeldstärken, bei denen die Impedanz der Wirbelstromspule 21 maximal ist. Durch einen Vergleich der Lageveränderungen der Impedanzmaxima bei vorgegebenen Prüffrequenzänderungen bestimmt die Auswerteschaltung diejenige Prüffrequenz, bei der eine Frequenzänderung eine maximale Lageveränderung des Impedanzmaximums bezüglich der absoluten Tangentialfeldstärke auslöst. Diese Prüffrequenz ist ein Maß für die Einhärtetiefe und die Dicke der Deckschicht 3.

Die Auswerteschaltung 24 gestattet unter Berücksichtigung der Überlagerungspermeabilität und der beispielsweise konstant angenommenen Leitfähigkeit eine Berechnung der der in der oben beschriebenen Weise ermittelten Prüffrequenz zugeordneten Eindringtiefe. Diese Eindringtiefe kann unmittelbar oder nach Korrektur durch eine Konstante und/oder einen Korrekturfaktor auf einer Anzeigevorrichtung 26 dargestellt werden.

Das in Fig. 2 dargestellte Ausführungsbeispiel der Erfindung gestattet somit die Bestimmung einer Prüffrequenz und daraus eine Ableitung der Einhärtetiefe.

**Patentansprüche**

1. Vorrichtung zum zerstörungsfreien Messen der Einhärtetiefe von Werkstoffen mit einem auf das zu untersuchende Material (1) mit seinen beiden Magnetpolen (9) aufsetzbaren Magnetisierungsjoch (5), dessen Erregerspule (6) zum Durchsteuern der Hysteresekurve des zu untersuchenden Materials (1) mit einem bipolaren Netzgerät (7) verbunden ist und zwischen dessen Magnetpolen (9) ein H-Feldmesser (16) zur Erfassung der Tangentialfeldstärke sowie ein induktiver Aufnehmer (10) angeordnet sind, die an einen Schaltkreis (14, 17) angeschlossen sind, der die Rauschamplitude der vom induktiven Aufnehmer (10) gelieferten Rauschspannung in Abhängigkeit von der Tangentialfeldstärke und die dem maximalen Wert der Rauschamplitude zugeordnete Tangentialfeldstärke ermittelt, dadurch gekennzeichnet, daß der induktive Aufnehmer (10) den Schaltkreis (14, 17) über ein verstellbares Filter (13) speist, dessen Durchlauffrequenz durch eine Auswerteschaltung (17) während eines Meßzyklus so weit erhöhbar ist, bis das dem Grundgefüge (2) zugeordnete bei der Koerzitivfeldstärke des Grundgefüges (2) auftretende Rauschmaximum unterdrückt und lediglich das bei der Koerzitivfeldstärke des Deckgefüges (3) auftretende Rauschmaximum meßbar ist, und daß die der so durch die Auswerteschaltung (17) ermittelten Grenzfrequenz zugeordnete Härtetiefe über eine Anzeigevorrichtung (18) darstellbar ist.

2. Vorrichtung zum zerstörungsfreien Messen der Einhärtetiefe von Werkstoffen mit einem auf das zu untersuchende Material (1) mit seinen beiden Magnetpolen (9) aufsetzbaren Magnetisierungsjoch (5), dessen Erregerspule (6) zum Durchsteuern der Hysteresekurve des zu untersuchenden Materials (1) mit einem bipolaren Netzgerät (7) verbunden ist und zwischen dessen Magnetpolen (9) ein H-Feldmesser (16) zur Erfassung der Tangentialfeldstärke sowie eine Wirbelstromspule (21) angeordnet sind, die an einen Wechselstromgenerator (22) mit einer gegenüber der Ausgangsfrequenz des Netzgerätes (7) hohen Prüffrequenz und an einen Impedanzmeßschaltkreis (23) angeschlossen ist, der die Impedanz der Wirbelstromspule (21) in Abhängigkeit von der Tangentialfeldstärke und die dem maximalen Wert der Impedanz zugeordnete Tangentialfeldstärke ermittelt, dadurch gekennzeichnet, daß dem Impedanzmeßschaltkreis eine Auswerteschaltung (24) zugeordnet ist, durch die Prüffrequenz des Wechselstromgenerators (22) verstellbar und durch die die der Härtetiefe zugeordnete Prüffrequenz feststellbar ist, bei der durch eine Veränderung der Prüffrequenz eine maximale Veränderung der einem Impedanzmaximum während des Durchsteuerns der Hysteresekurve zugeordneten Tangentialfeldstärke auslösbar ist.

3. Vorrichtung nach Anspruch 1, dadurch gekennzeichnet, daß das Filter (13) ein Bandfilter mit einer Mittenfrequenz ist, die zwischen 1 kHz und 500 hHz verstellbar ist.

4. Vorrichtung nach Anspruch 1, dadurch gekennzeichnet, daß das Filter (13) ein Hochpaß ist, dessen Grenzfrequenz zwischen 1 kHz und 500 kHz verstellbar ist.

5. Vorrichtung nach Anspruch 2, dadurch gekennzeichnet, daß die Prüffrequenz des Wechselstromgenerators (22) zwischen 20 kHz und 2 MHz verstellbar ist.

6. Vorrichtung nach Anspruch 1, dadurch gekennzeichnet, daß die Filterfrequenz für die Messung von Härteschichten von etwa 0,1 mm bis 1 mm Dicke ausgelegt ist.

7. Vorrichtung nach Anspruch 2, dadurch gekennzeichnet, daß die Prüffrequenz für die Analyse dünnster Härteschichten von weniger als 100 µm ausgelegt ist.

## Claims

1. A device for the non-destructive measuring of the hardening depth of materials having a magnetization yoke (5) which can be placed with its two magnetic poles (9) on the material (1) to be examined and the exciting coil (6) of which is connected to a bipolar power-supply unit (7) to control the hysteresis curve of the material (1) to be examined and between the magnetic poles (9) of which there are disposed an H-field measuring device (16) to detect the tangential field strength and an inductive receiver (10) which are connected to a switching network (14, 17) which determines the noise amplitude of the noise voltage delivered by the inductive receiver (10) depending on the tangential field strength and the tangential field strength associated with the maximum value of the noise amplitude, characterised in that the inductive receiver (10) feeds the switching network (14, 17) via an adjustable filter (13), the pass frequency of which can be raised by an evaluation circuit (17) during a measuring cycle until the noise maximum associated with the underlying structure (2) and appearing at the coercive field strength of the underlying structure (2) is suppressed and only the noise maximum appearing at the coercive field strength of the covering structure (3) can be measured, and that the hardening depth associated with the limit frequency thus determined by the evaluation circuit (17) can be displayed via an indicating device (18).

2. A device for the non-destructive measuring of the hardening depth of materials, having a magnetization yoke (5) which can be placed with its two magnetic poles (9) on the material (1) to be examined and the exciting coil (6) of which is connected to a bipolar power-supply unit (7) to control the hysteresis curve of the material (1) to be examined and between the magnetic poles (9) of which there are disposed an H-field measuring device (16) to detect the tangential field strength and an eddy-current coil (21) which is connected to an alternating-current generator (22) having a high test frequency in comparison with the output frequency of the power-supply unit (7) and to an impedance-measuring switching circuit (23) which determines the impedance of the eddy-current coil (21) depending on the tangential field strength and the tangential field strength associated with the maximum value of the impedance, characterised in that associated with the impedance-measuring switching circuit is an evaluation circuit (24) by which the test frequency of the alternating-current generator (22) is adjustable and by which the test frequency associated with the hardening depth can be ascertained, at which a maximum variation in the tangential field strength associated with an impedance maximum during the control of the hysteresis curve can be produced by a variation in the test frequency.

3. A device as claimed in Claim 1, characterised in that the filter (13) is a band-pass filter with a centre frequency which can be adjusted between 1 kHz and 500 kHz.

4. A device as claimed in Claim 1, characterised in that the filter (13) is a high-pass filter, the limit frequency of which can be adjusted between 1 kHz and 500 kHz.

5. A device as claimed in Claim 2, characterised in that the test frequency of the alternating-current generator (22) is adjustable between 20 kHz and 2 MHz.

6. A device as claimed in Claim 1, characterised in that the filter frequency is designed for the measurement of hardening layers from about 0.1 mm to 1 mm in thickness.

7. A device as claimed in Claim 2, characterised in that the frequency is designed for the analysis of very thin hardened layers of less than 100 µm.

## Revendications

1. Dispositif pour la mesure non destructive de la profondeur de trempe de matériaux, comportant un étrier de magnétisation (5) pouvant être appliqué par ses deux pôles magnétiques (9) sur le matériau à tester (1), dont la bobine d'excitation (6) est connectée, pour la commande de balayage de la courbe d'hystérésis du matériau à tester (1), à un appareil d'alimentation bipolaire (7), et entre les pôles magnétiques (9) duquel sont disposés un appareil de mesure de champ en H (16) pour la détermination de l'intensité de champ tangentiel, ainsi qu'un capteur inductif (10) qui est raccordé à un circuit (14, 17) déterminant l'amplitude de bruit de la tension de bruit fournie par le capteur inductif (10) en fonction de l'intensité de champ tangentiel et l'intensité de champ tangentiel associée à la valeur maximale de l'amplitude de bruit, caractérisé en ce que le capteur inductif (10) alimente le circuit (14, 17) par l'intermédiaire d'un filtre réglable (13) dont la fréquence de transmission ou de passage peut être augmentée au moyen d'un circuit d'évaluation (17) pendant un cycle de mesure, jusqu'à ce que le maximum de bruit associé à la texture de base (2) et engendré pour l'intensité de champ coercitif de cette texture de base (2) soit supprimé ou atténué et que seul le maximum de bruit apparaissant pour l'intensité de champ coercitif de la texture de recouvrement (3) soit mesurable, et en ce que la profondeur de trempe associée à la fréquence limite déterminée ainsi par le circuit d'évaluation (17) peut être représentée ou affichée par l'intermédiaire d'un dispositif indicateur (18).

2. Dispositif pour la mesure non destructive de la profondeur de trempe de matériaux, comportant un étrier de magnétisation (5) pouvant être appliqué par ses deux pôles magnétiques (9) sur le matériau à tester (1), dont la bobine d'excitation (6) est connectée, pour la commande de balayage de la courbe d'hystérésis du matériau à tester (1), à un appareil d'alimentation bipolaire (7), et entre les pôles magnétiques (9) duquel sont disposés un appareil de mesure de champ en H (16) pour la détermination de l'intensité de champ tangentiel, ainsi qu'une bobine à courants de Foucault (21) qui est raccordée à un générateur de courant alternatif (22) ayant une fréquence de contrôle ou de test élevée par rapport à la fréquence de sortie de l'appareil d'alimentation (7) et à un circuit de mesure d'impédance (23) qui détermine l'impédance de la bobine à courants de Foucault (21) en fonction de l'intensité de champ tangentiel et l'intensité de champ tangentiel asscociée à la valeur d'impédance maximale, caractérisé en ce qu'il est prévu, en combinaison avec le circuit de mesure d'impédance, un circuit d'évaluation (24) par lequel la fréquence de contrôle ou de texte du générateur de courant alternatif (22) est réglable et par lequel la fréquence de contrôle associée à la profondeur de trempe, pour laquelle une variation maximale de l'intensité de champ tangentiel associée à un maximum d'impédance pendant la commande de balayage de la courbe d'hystérésis peut être déclenchée par une variation de la fréquence de contrôle, peut être déterminée.

3. Dispositif suivant la revendication 1, caractérisé en ce que le filtre (13) est un filtre passe-bande ayant une fréquence moyenne réglable entre 1 kHz et 500 kHz.

4. Dispositif suivant la revendication 1, caractérisé en ce que le filtre est un filtre passe-haut dont la fréquence limite est réglable entre 1 kHz et 500 kHz.

5. Dispositif suivant la revendication 2, caractérisé en ce que la fréquence de contrôle du générateur de courant alternatif (22) est réglable entre 20 kHz et 2 MHz.

6. Dispositif suivant la revendication 1, caractérisé en ce que la fréquence du filtre est choisie pour la mesure de couches de trempe, d'une épaisseur de 0,1 mm à 1 mm environ.

7. Dispositif suivant la revendication 2, caractérisé en ce que la fréquence de contrôle est choisie pour l'analyse de couches de trempe très minces ayant moins de 100 μm.

Fig.1

Fig. 2